# EUROPEAN PATENT APPLICATION

(11) **EP 4 708 670 A1**
(43) Date of publication of application: **11.03.2026**
(21) Application number: 24871298.6
(22) Date of filing: 09.02.2024
(51) Int. Cl.: H02S 10/30, H10F 10/00, H02S 40/22, H02S 40/42

(54) **POWER GENERATION SYSTEM, POWER GENERATION UNIT, AND METHOD FOR MANUFACTURING POWER GENERATION UNIT**

(30) Priority: 27.09.2023 JP 2023166210
(71) Applicant: Mitsubishi Heavy Industries, Ltd., Tokyo 100-8332 (JP); Tohoku University, Sendai-shi, Miyagi 980-8577 (JP)
(72) Inventor: KAMIHARA, Nobuyuki, Tokyo 100-8332 (JP); TAKEUCHI, Yoshiaki, Tokyo 100-8332 (JP); SHIMIZU, Makoto, Sendai-shi, Miyagi 980-8577 (JP); YUGAMI, Hiroo, Sendai-shi, Miyagi 980-8577 (JP)
(74) Representative: Studio Torta S.p.A.
(86) International application number: PCT/JP2024/004683
(87) International publication number: WO 2025/069480

(57) **Abstract**

A power generation system includes an emitter heated by heat supplied from a heat source and configured to emit an infrared ray, and a power generation unit disposed at an interval from the emitter and configured to generate power by converting the infrared ray emitted from the emitter into electric energy. The power generation unit includes a power generation section including a photoelectric conversion element configured to convert the infrared ray emitted from the emitter into the electric energy, and a reflection section provided on a side opposite to a side of the emitter with respect to the power generation section and configured to reflect at least a portion of the infrared ray transmitted through the power generation section to the side of the emitter.

## Description

### TECHNICAL FIELD

The present disclosure relates to a power generation system, a power generation unit, and a method for manufacturing a power generation unit.

Priority is claimed on Japanese Patent Application No. 2023-166210, filed September 27, 2023, the content of which is incorporated herein by reference.

### BACKGROUND ART

Patent Document 1 discloses a configuration for power generation using thermophotovoltaic (TPV), in which an emitter (radiator) is heated to convert an infrared ray emitted from the emitter into electric energy in a photoelectric conversion cell.

### Citation List

### Patent Document

Patent Document 1: Japanese Unexamined Patent Application, First Publication No. 2001-196622

### SUMMARY OF INVENTION

### Technical Problem

However, in the configuration disclosed in Patent Document 1, the photoelectric conversion cell that can highly efficiently convert light in a wavelength range of the infrared ray emitted from the emitter into electric energy is formed of a special material, compared to a solar panel. Consequently, the configuration requires high costs.

On the other hand, when a commercially available solar panel is applied to TPV power generation at low costs, a wavelength range of the infrared ray emitted from the emitter and a wavelength range in which power can be efficiently generated with the solar panel using visible light do not match each other, and the power cannot be efficiently generated.

The present disclosure provides a power generation system, a power generation unit, and a method for manufacturing a power generation unit, which can efficiently generate power while suppressing costs.

### Solution to Problem

According to the present disclosure, there is provided a power generation system including an emitter heated by heat supplied from a heat source and configured to emit an infrared ray, and a power generation unit disposed at an interval from the emitter and configured to generate power by converting the infrared ray emitted from the emitter into electric energy. The power generation unit includes a power generation section including a photoelectric conversion element configured to convert the infrared ray emitted from the emitter into the electric energy, and a reflection section provided on a side opposite to a side of the emitter with respect to the power generation section and configured to reflect at least a portion of the infrared ray transmitted through the power generation section to the side of the emitter.

According to the present disclosure, there is provided a power generation unit used in the power generation system. The power generation unit includes a power generation section including a photoelectric conversion element configured to convert the infrared ray emitted from the emitter into the electric energy; and a reflection section provided on the side opposite to the side of the emitter with respect to the power generation section and configured to reflect at least a portion of the infrared ray transmitted through the power generation section to the side of the emitter.

According to the present disclosure, there is provided a method for manufacturing the power generation unit. The method for manufacturing the power generation unit includes a step of preparing the power generation section and the reflection section, and a step of laminating the power generation section and the reflection section.

### Advantageous Effects of Invention

According to the power generation system, the power generation unit, and the method for manufacturing the power generation unit of the present disclosure, power can be efficiently generated while costs can be suppressed.

### BRIEF DESCRIPTION OF DRAWINGS

[FIG. 1] A diagram showing the schematic configuration of a power generation system according to an embodiment of the present disclosure.
[FIG. 2] A flowchart showing a procedure of a method for manufacturing a power generation unit according to the embodiment of the present disclosure.
[FIG. 3] A diagram showing a modification example of the power generation system.
[FIG. 4] A diagram showing another modification example of the power generation system.

### DESCRIPTION OF EMBODIMENTS

Hereinafter, embodiments of a power generation system, a power generation unit, and a method for manufacturing a power generation unit according to the present disclosure will be described with reference to the accompanying drawings. However, the present disclosure is not limited only to the embodiments.

### (Configuration of Power Generation System)

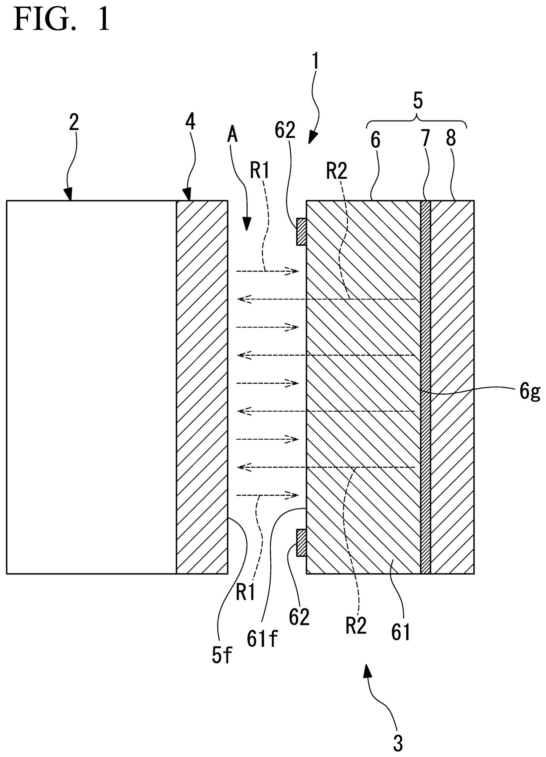

As shown in FIG. 1, a power generation system 1 includes a heat source 2 and a system main body 3.

The heat source 2 may be exclusively provided to heat an emitter 4 (to be described below). The heat source 2 may be used for other applications, and may heat the emitter 4 by using waste heat discharged from the heat source 2. Examples of such a heat source 2 include a gas turbine, a solar concentrator, and the like.

A method of heating the emitter 4 by using the heat source 2 is not limited. Examples of the method for heating the emitter 4 by using the heat source 2 include using the waste heat of the gas turbine and irradiation of concentrated sunlight.

### (Configuration of System Main Body)

The system main body 3 includes the emitter 4 and a power generation unit 5. In the present embodiment, for example, the system main body 3 is accommodated inside a vacuum chamber (not shown). Without being accommodated inside the vacuum chamber, the system main body 3 may be disposed in an atmospheric atmosphere.

### (Configuration of Emitter)

The emitter 4 is heated by heat supplied from the heat source 2. The emitter 4 is heated to emit an infrared ray R1. Here, as the temperature of the emitter 4 increases, the energy amount of the infrared ray R1 emitted from the emitter 4 increases. For example, it is preferable that the emitter 4 is heated to 1,000°C or higher.

It is preferable that the emitter 4 has a melting point equal to or higher than a temperature at which the emitter 4 is heated by the heat source 2. For example, as a material for forming the emitter 4, ceramics, bricks, metal having a melting point equal to or higher than a heating temperature, and the like may be used as examples.

The shape and the size of the emitter 4 may be determined in any desired way. For example, the emitter 4 may have a panel shape, a block shape, a cylindrical shape, or the like.

It is preferable that the emitter 4 has an emitter-side facing surface 5f facing a side of a power generation section 6 (to be described later).

In order to improve emission efficiency of the infrared ray R1, it is preferable that a surface of the emitter 4 has a black color. In particular, it is preferable that a coating film formed of a blackbody paint is formed on the surface of the emitter 4. In this case, the entire surface of the emitter 4 may be covered with the coating film formed of the blackbody paint, or at least the emitter-side facing surface 5f may be covered with the coating film formed of the blackbody paint.

### (Configuration of Power Generation Unit)

The power generation unit 5 includes the power generation section 6, a reflection section 7, and a cooling section 8. In the present embodiment, each of the power generation section 6, the reflection section 7, and the cooling section 8 is formed in a plate shape having a predetermined thickness. In the present embodiment, the power generation section 6, the reflection section 7, and the cooling section 8 are sequentially laminated in this order.

The power generation section 6 is disposed at an interval from the emitter 4.

The power generation section 6 includes a photoelectric conversion element 61 that generates power by converting the infrared ray R1 emitted from the emitter 4 into electric energy, and a collecting electrode 62.

The photoelectric conversion element 61 has a surface 61f facing a side of the emitter 4. The power generation section 6 generates the electric energy by a photovoltaic effect using the infrared ray R1 incident on the inside from the surface 61f.

The collecting electrode 62 is provided to extract power outward from a transparent electrode (not shown) provided on the surface 61f of the photoelectric conversion element 61.

As the photoelectric conversion element 61, it is preferable to use a semiconductor substrate using a silicon material such as single crystal silicon or amorphous silicon, a glass material, sapphire, or the like. Among these materials, in a case of using the semiconductor substrate using the silicon material used in a solar panel, that is, a so-called silicon substrate, the configuration requires low costs.

It is preferable that the surface 61f of the photoelectric conversion element 61 does not include an antireflection film as provided in the solar panel. That is, it is preferable that only an atmosphere A of a space in which the power generation system 1 is installed is interposed between the surface 61f of the photoelectric conversion element 61 and the emitter 4. The atmosphere A interposed between the surface 61f of the photoelectric conversion element 61 and the emitter 4 may be an atmosphere, or may be a gas such as nitrogen. In addition, when the power generation system 1 is accommodated inside a vacuum chamber, the atmosphere A interposed between the surface 61f of the photoelectric conversion element 61 and the emitter 4 may be the atmosphere A having a predetermined degree of vacuum or higher inside the vacuum chamber.

In addition, even when the collecting electrode 62 is provided in a portion of the surface 61f, in a portion excluding a portion where the collecting electrode 62 is provided, only the atmosphere A of the space is interposed between the surface 61f and the emitter 4. Therefore, it can be described that only the atmosphere A of the space is substantially interposed between the surface 61f and the emitter 4.

In addition, it is preferable that the surface 61f of the photoelectric conversion element 61 does not include a surface treatment section such as uneven processing for antireflection as provided in the solar panel. It is preferable that the surface 61f of the photoelectric conversion element 61 according to the present embodiment is a smooth surface.

The reflection section 7 is provided on a side opposite to a side of the emitter 4 with respect to the power generation section 6. The reflection section 7 is provided to cover the back surface 6g of the power generation section 6. The reflection section 7 is formed in a film shape extending along a back surface 6g. The reflection section 7 may have a plate shape provided to extend along the back surface 6g.

The reflection section 7 reflects at least a portion of the infrared ray R1 transmitted through the power generation section 6 to the side of the emitter 4. The reflection section 7 is formed of a reflective material that can reflect the infrared ray. Examples of the reflective material include gold, silver, aluminum, and the like.

The reflection section 7 is joined to the power generation section 6 by vapor deposition, adhesion, or the like through sputtering.

The cooling section 8 is provided on a side opposite to a side of the power generation section 6 with respect to the reflection section 7. The cooling section 8 is provided to cover at least a portion of the reflection section 7. It is preferable that the cooling section 8 is provided to cover the entire reflection section 7.

The cooling section 8 cools the power generation section 6 and the reflection section 7, in which temperatures are raised due to the infrared ray. For example, the cooling section 8 may be a heat sink formed of an aluminum alloy or the like, absorbing the heat from the reflection section 7, and dissipating the heat to the periphery. In addition, for example, the cooling section 8 may be a heat exchanger exchanging the heat with the reflection section 7 through heat exchange with a refrigerant introduced from the outside.

In the power generation system 1 configured in this way, when the emitter 4 is heated by the heat supplied from the heat source 2, the infrared ray R1 is emitted from the emitter 4. The infrared ray R1 emitted from the emitter 4 is incident on the power generation section 6 of the power generation unit 5 disposed at an interval from the emitter 4, and is converted into the electric energy to generate power by the photoelectric conversion element 61.

Here, when the same silicon substrate as that used in the solar panel is used for the photoelectric conversion element 61, it is preferable to configure the power generation system 1 such that the power generation section 6 generates the power in a temperature range of 50°C or higher and 150°C or lower. It is more preferable that the temperature range in which the power generation section 6 generates the power is 70°C or higher and 130°C or lower. It is particularly preferable that the temperature range when the power generation section 6 generates the power is 90°C or higher and 110°C or lower. In this way, photoelectric conversion efficiency can be particularly improved by the photovoltaic effect.

A portion of the infrared ray R1 emitted from the emitter 4 is transmitted through the power generation section 6. At least a portion of the infrared ray R1 transmitted through the power generation section 6 is reflected from the reflection section 7 to the side of the emitter 4. When an infrared ray R2 reflected to the side of the emitter 4 by the reflection section 7 is emitted to the emitter 4, the emitter 4 is heated. In this way, the emitter 4 is heated by the infrared ray R2 reflected to the side of the emitter 4 by the reflection section 7, in addition to the heat supplied from the heat source 2. In this manner, the temperature of the emitter 4 is further raised, and an energy amount of the infrared ray R1 emitted from the emitter 4 increases.

### (Procedure of Method for Manufacturing Power Generation Unit)

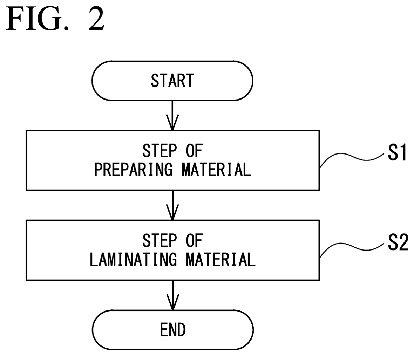

FIG. 2 is a flowchart showing a procedure of a method for manufacturing the power generation unit 5 in the present embodiment.

As shown in FIG. 2, the method for manufacturing the power generation unit 5 includes Step S1 of preparing a material and Step S2 of laminating the material.

In Step S1 of preparing the material, each of a member forming the power generation section 6, a material or a member forming the reflection section, and a member forming the cooling section 8 is prepared as a material forming the power generation unit 5.

Next, in Step S2 of laminating the material, the member forming the power generation section 6, the material or the member forming the reflection section, and the member forming the cooling section 8, which are prepared in Step S1 of preparing the material, are laminated and joined. Here, the reflection section 7 may be vapor-deposited on the member forming the power generation section 6, or the plate-shaped reflection section 7 prepared in Step S1 of preparing the material may be joined to the power generation section 6.

In this way, the power generation unit 5 is manufactured.

### (Operational Effect)

In the power generation system 1, the power generation unit 5, and the method for manufacturing the power generation unit 5, which have the above-described configurations, the infrared ray R1 is emitted from the emitter 4 heated by the heat supplied from the heat source 2. The infrared ray R1 emitted from the emitter 4 is converted into the electric energy to generate the power in the power generation section 6 of the power generation unit 5 disposed at an interval from the emitter 4. The portion of the infrared ray R1 emitted from the emitter 4 is transmitted through the power generation section 6. At least the portion of the infrared ray R1 transmitted through the power generation section 6 is reflected to the side of the emitter 4 by the reflection section 7 provided on a side opposite to the emitter 4 with respect to the power generation section 6. In this manner, the emitter 4 is also heated by the infrared ray R2 reflected to the side of the emitter 4 by the reflection section 7.

In this way, the emitter 4 is heated by the infrared ray R2 reflected to the side of the emitter 4 by the reflection section 7, in addition to the heat supplied from the heat source 2. In this manner, the temperature of the emitter 4 is further raised, and the energy amount of the infrared ray R1 emitted from the emitter 4 increases. In addition, the heat supplied from the heat source 2 can be reduced as much as a heated amount of the emitter 4 by the infrared ray R2 reflected to the side of the emitter 4 by the reflection section 7.

Therefore, a ratio of effectively utilizing the infrared ray R1 emitted from the emitter 4 becomes higher, and power generation efficiency in the entire power generation system 1 is improved. In addition, the improved power generation efficiency leads to substantially reduced costs even when the same photoelectric conversion element 61 is used.

As a result, the power can be efficiently generated while the costs are suppressed.

In addition, since the photoelectric conversion element 61 formed of the silicon material is used, for example, a material of the solar panel for solar power generation can be used as the power generation section 6. Since a large amount of the solar panels is produced at low costs, the costs can be more effectively suppressed.

In addition, the cooling section 8 can cool the power generation section 6 and the reflection section 7, and the power generation efficiency in the power generation section 6 can be improved.

In addition, since the emitter 4 is heated in a high temperature range of 1,000°C or higher, the energy amount of the infrared ray R1 emitted from the emitter 4 can be increased, and the power can be more efficiently generated.

In addition, when the power generation section 6 generates the power in a temperature range of 50°C or higher and 150°C or lower, the power generation efficiency can be improved, compared to when the power is generated in a so-called normal temperature range lower than 50°C.

In addition, since only the atmosphere A of the space in which the power generation system 1 is installed is interposed between the power generation section 6 and the emitter 4, the infrared ray R1 emitted from the emitter 4 is directly incident on the power generation section 6. In this manner, the energy amount of the infrared ray R1 incident on the power generation section 6 is increased, compared to when the surface 61f of the power generation section 6 includes the antireflection film, and the power can be more efficiently generated.

In addition, since the surface 61f of the power generation section 6 is the smooth surface, the infrared ray R1 emitted from the emitter 4 is efficiently incident on the power generation section 6. In this manner, the energy amount of the infrared ray R1 incident on the power generation section 6 is increased, compared to when various surface treatments for the antireflection or the like are performed on the surface 61f of the power generation section 6, and the power can be more efficiently generated.

### (Modification Example of Embodiment)

In the above-described embodiment, in order to improve collecting efficiency in the collecting electrode 62, the photoelectric conversion element 61 may include a doped section in which an n-type semiconductor has a high concentration. However, the doped section hinders incidence of the infrared ray in the power generation section 6.

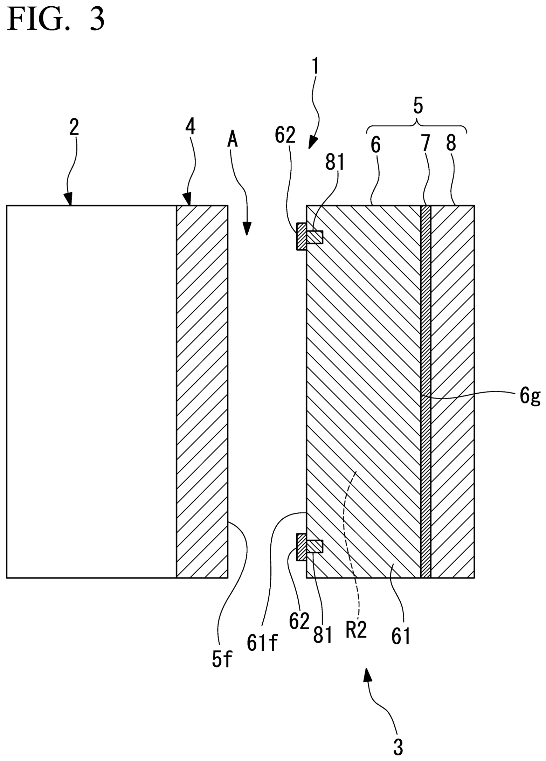

Therefore, for example, as shown in FIG. 3, a doped section 81 may be provided only around the collecting electrode 62, and an area where the infrared ray is blocked by the doped section 81 may be minimized as much as possible.

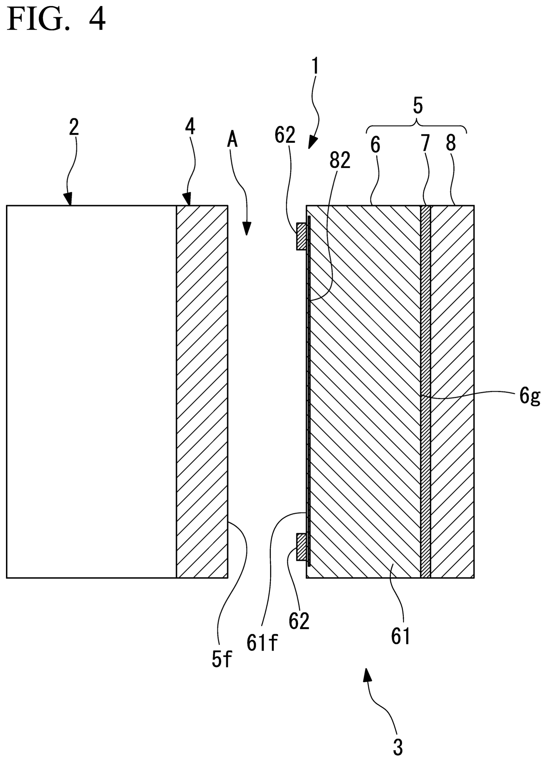

In addition, as shown in FIG. 4, when the layer-like (film-like) doped section 82 is provided along the surface of the photoelectric conversion element 61, it is preferable that the thickness of the doped section 82 is as small as possible.

In addition, in the above-described embodiment, the surface 61f of the photoelectric conversion element 61 does not include a surface treatment section such as the antireflection film or uneven processing for the antireflection, which is provided in the solar panel, but the present invention is not limited thereto. For example, when a commercially available solar panel including the antireflection film on the surface or the surface treatment section for antireflection is used as the photoelectric conversion element 61, the power generation unit 5 and the power generation system 1 can be configured at low costs. In this case, although incidence efficiency of the infrared ray on the photoelectric conversion element 61 is lowered by the antireflection film or the surface treatment section for the antireflection, the power generation efficiency is improved since a portion of the infrared ray is reflected to the emitter 4 by the reflection section 7.

In addition, when a commercially available solar panel including the antireflection film or the surface treatment section for the antireflection is used as the photoelectric conversion element 61, the antireflection film or the surface treatment section for the antireflection may be removed.

In this case, when the power generation unit 5 is manufactured in a flow shown in FIG. 2, and when the member forming the power generation section 6 is prepared in Step S1 of preparing the material, the surface treatment section such as the antireflection film or the uneven processing for the antireflection may be removed from a surface of the commercially available solar panel by appropriate machining, chemical treatments, or the like.

### <Appendix>

The power generation system, the power generation unit, and the method for manufacturing the power generation unit, which are described in the embodiment, are understood as follows, for example.
(1) According to a first aspect, the power generation system 1 includes the emitter 4 heated by the heat supplied from the heat source 2 and configured to emit the infrared ray R1, and the power generation unit 5 disposed at an interval from the emitter 4 and configured to generate the power by converting the infrared ray R1 emitted from the emitter 4 into the electric energy. The power generation unit 5 includes the power generation section 6 including the photoelectric conversion element configured to convert the infrared ray R1 emitted from the emitter 4 into the electric energy, and the reflection section 7 provided on the side opposite to the side of the emitter 4 with respect to the power generation section 6 and configured to reflect at least a portion of the infrared ray R1 transmitted through the power generation section 6 to the side of the emitter 4.

In the power generation system 1, the infrared ray R1 is emitted from the emitter 4 heated by the heat supplied from the heat source 2. The infrared ray R1 emitted from the emitter 4 is converted into the electric energy to generate the power in the power generation section 6 of the power generation unit 5 disposed at an interval from the emitter 4. A portion of the infrared ray R1 emitted from the emitter 4 is transmitted through the power generation section 6. At least a portion of the infrared ray R1 transmitted through the power generation section 6 is reflected to the side of the emitter 4 by the reflection section 7 provided on a side opposite to the emitter 4 with respect to the power generation section 6. In this manner, the emitter 4 is also heated by the infrared ray R2 reflected to the side of the emitter 4 by the reflection section 7.

In this way, the emitter 4 is heated by the infrared ray R2 reflected to the side of the emitter 4 by the reflection section 7, in addition to the heat supplied from the heat source 2. In this manner, the temperature of the emitter 4 is further raised, and the energy amount of the infrared ray R1 emitted from the emitter 4 increases. In addition, the heat supplied from the heat source 2 can be reduced as much as a heated amount of the emitter 4 by the infrared ray R2 reflected to the side of the emitter 4 by the reflection section 7.

Therefore, a ratio of effectively utilizing the infrared ray R1 emitted from the emitter 4 becomes higher, and power generation efficiency in the entire power generation system 1 is improved.

In addition, the improved power generation efficiency leads to substantially reduced costs even when the same photoelectric conversion element 61 is used.

As a result, the power can be efficiently generated while the costs are suppressed.

(2) As the power generation system 1 according to a second aspect, in the power generation system 1 according to (1), the photoelectric conversion element 61 is formed of the silicon material.

As the power generation section 6 including the photoelectric conversion element 61 formed of the silicon material, for example, a so-called solar panel for solar power generation can be used. Since a large amount of the solar panels is produced at low costs, the costs can be more effectively suppressed.

(3) As the power generation system 1 according to a third aspect, the power generation system 1 according to (1) or (2) further includes the cooling section 8 configured to cool the power generation section 6 and the reflection section 7.

In this manner, the cooling section 8 can cool the power generation section 6 and the reflection section 7, and the power generation efficiency in the power generation section 6 can be improved.

(4) As the power generation system 1 according to a fourth aspect, in the power generation system 1 according to any one of (1) to (3), the emitter 4 is heated to 1,000°C or higher.

In this manner, since the emitter 4 is heated in a high temperature range of 1,000°C or higher, the energy amount of the infrared ray R1 emitted from the emitter 4 can be increased, and the power can be more efficiently generated.

(5) As the power generation system 1 according to a fifth aspect, in the power generation system 1 according to any one of (1) to (4), the power generation section 6 generates the power in a temperature range of 50°C or higher and 150°C or lower.

In this manner, since the power generation section 6 generates the power in the temperature range of 50°C or higher and 150°C or lower, the power generation efficiency can be improved, compared to when the power is generated in a so-called normal temperature range lower than 50°C.

(6) As the power generation system 1 according to a sixth aspect, in the power generation system 1 according to any one of (1) to (5), only the atmosphere A of the space in which the power generation section 6 and the emitter 4 are disposed is interposed between the power generation section 6 and the emitter 4.

In this manner, since only the atmosphere A of the space is interposed between the power generation section 6 and the emitter 4, the infrared ray R1 emitted from the emitter 4 is directly incident on the power generation section 6. In this manner, the energy amount of the infrared ray R1 incident on the power generation section 6 is increased, compared to when the surface 61f of the power generation section 6 includes the antireflection film, and the power can be more efficiently generated.

(7) As the power generation system 1 according to a seventh aspect, in the power generation system 1 according to any one of (1) to (6), in the power generation section 6, the surface 61f facing the side of the emitter 4 is the smooth surface.

In this manner, since the surface 61f of the power generation section 6 is the smooth surface, the infrared ray R1 emitted from the emitter 4 is efficiently incident on the power generation section 6. In this manner, the energy amount of the infrared ray R1 incident on the power generation section 6 is increased, compared to when various surface 61f treatments for the antireflection or the like are performed on the surface 61f of the power generation section 6, and the power can be more efficiently generated.

(8) According to an eighth aspect, there is provided a power generation unit used in the power generation system according to any one of (1) to (7). The power generation unit includes the power generation section 6 including the photoelectric conversion element configured to convert the infrared ray R1 emitted from the emitter 4 into the electric energy, and the reflection section 7 provided on the side opposite to the side of the emitter 4 with respect to the power generation section 6 and configured to reflect at least a portion of the infrared ray R1 transmitted through the power generation section 6 to the side of the emitter 4.

In this manner, the infrared ray R1 emitted from the emitter 4 is converted into the electric energy in the power generation section 6 of the power generation unit 5 disposed at an interval from the emitter 4. A portion of the infrared ray R1 emitted from the emitter 4 is transmitted through the power generation section 6. At least a portion of the infrared ray R1 transmitted through the power generation section 6 is reflected to the side of the emitter 4 by the reflection section 7 provided on a side opposite to the emitter 4 with respect to the power generation section 6. In this manner, the emitter 4 is also heated by the infrared ray R2 reflected to the side of the emitter 4 by the reflection section 7.

In this way, the emitter 4 is heated by the infrared ray R2 reflected to the side of the emitter 4 by the reflection section 7, in addition to the heat supplied from the heat source 2. In this manner, the temperature of the emitter 4 is further raised, and the energy amount of the infrared ray R1 emitted from the emitter 4 increases. In addition, the heat supplied from the heat source 2 can be reduced as much as a heated amount of the emitter 4 by the infrared ray R2 reflected to the side of the emitter 4 by the reflection section 7.

Therefore, a ratio of effectively utilizing the infrared ray R1 emitted from the emitter 4 becomes higher, and power generation efficiency in the power generation unit 5 is improved.

In addition, the improved power generation efficiency leads to substantially reduced costs even when the same photoelectric conversion element 61 is used.

As a result, the power can be efficiently generated while the costs are suppressed.

(9) According to a ninth aspect, there is provided a method for manufacturing the power generation unit 5 according to (8). The method for manufacturing the power generation unit 5 includes Step S1 of preparing the power generation section 6 and the reflection section 7, and Step S2 of laminating the power generation section 6 and the reflection section 7.

In this manner, it is possible to manufacture the power generation unit 5 that can efficiently generate the power while suppressing the costs.

(10) As the method for manufacturing the power generation unit 5 according to a tenth aspect, in the method for manufacturing the power generation unit 5 according to (9), in the step of preparing the power generation section 6 and the reflection section 7, the film formed to cover the surface of the power generation section 6 is removed.

In this manner, since the film formed to cover the power generation section 6 is removed, the infrared ray R1 emitted from the emitter 4 is directly incident on the power generation section 6. In this manner, the energy amount of the infrared ray R1 incident on the power generation section 6 is increased, and the power can be more efficiently generated.

### INDUSTRIAL APPLICABILITY

According to the power generation system, the power generation unit, and the method for manufacturing the power generation unit of the present disclosure, power can be efficiently generated while costs can be suppressed.

### REFERENCE SIGNS LIST

1 Power generation system
2 Heat source
3 System main body
4 Emitter
5 Power generation unit
5f Emitter-side facing surface
6 Power generation section
6g Back surface
7 Reflection section
8 Cooling section
61 Photoelectric conversion element
61f Surface
62 Collecting electrode
81, 82 Doped section
A Atmosphere
R1, R2 Infrared ray
S1 Step of preparing material
S2 Step of laminating material

## Claims

1. A power generation system comprising:
an emitter heated by heat supplied from a heat source and configured to emit an infrared ray; and
a power generation unit disposed at an interval from the emitter and configured to generate power by converting the infrared ray emitted from the emitter into electric energy,
wherein the power generation unit includes
a power generation section including a photoelectric conversion element configured to convert the infrared ray emitted from the emitter into the electric energy, and
a reflection section provided on a side opposite to a side of the emitter with respect to the power generation section and configured to reflect at least a portion of the infrared ray transmitted through the power generation section to the side of the emitter.

2. The power generation system according to Claim 1,
wherein the photoelectric conversion element is formed of a silicon material.

3. The power generation system according to Claim 1 or 2, further comprising:
a cooling section configured to cool the power generation section and the reflection section.

4. The power generation system according to Claim 1 or 2,
wherein the emitter is heated to 1,000°C or higher.

5. The power generation system according to Claim 1 or 2,
wherein the power generation section generates the power in a temperature range of 50°C or higher and 150°C or lower.

6. The power generation system according to Claim 1 or 2,
wherein only an atmosphere of a space in which the power generation section and the emitter are disposed is interposed between the power generation section and the emitter.

7. The power generation system according to Claim 1 or 2,
wherein in the power generation section, a surface facing the side of the emitter is a smooth surface.

8. A power generation unit used in the power generation system according to Claim 1 or 2, comprising:
a power generation section including a photoelectric conversion element configured to convert the infrared ray emitted from the emitter into the electric energy; and
a reflection section provided on the side opposite to the side of the emitter with respect to the power generation section and configured to reflect at least a portion of the infrared ray transmitted through the power generation section to the side of the emitter.

9. A method for manufacturing the power generation unit according to Claim 8, the method comprising:
a step of preparing the power generation section and the reflection section; and
a step of laminating the power generation section and the reflection section.

10. The method for manufacturing the power generation unit according to Claim 9,
wherein in the step of preparing the power generation section and the reflection section, a film formed to cover a surface of the power generation section is removed.
